(19) Europäisches Patentamt / European Patent Office / Office européen des brevets

(11) **EP 4 204 823 B1**

(12) **EUROPÄISCHE PATENTSCHRIFT**

(45) Veröffentlichungstag und Bekanntmachung des Hinweises auf die Patenterteilung:
**23.07.2025 Patentblatt 2025/30**

(21) Anmeldenummer: **21782449.9**

(22) Anmeldetag: **13.09.2021**

(51) Internationale Patentklassifikation (IPC):
*G01R 15/16* (2006.01)    *H01G 4/28* (2006.01)
*H01G 4/38* (2006.01)

(52) Gemeinsame Patentklassifikation (CPC):
**G01R 15/16; H01G 4/28; H01G 4/38**

(86) Internationale Anmeldenummer:
**PCT/EP2021/075046**

(87) Internationale Veröffentlichungsnummer:
**WO 2022/069193 (07.04.2022 Gazette 2022/14)**

(54) **FELDSONDENKOMBINATION ZUR VERWENDUNG BEI MITTEL- UND HOCHSPANNUNGEN**

FIELD SENSOR COMBINATION FOR USE WITH MEDIUM AND HIGH VOLTAGES

AGENCEMENT DE CAPTEURS DE CHAMP DESTINÉ À ÊTRE UTILISÉ AVEC DES TENSIONS MOYENNES ET HAUTES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.09.2020 DE 102020212404**

(43) Veröffentlichungstag der Anmeldung:
**05.07.2023 Patentblatt 2023/27**

(73) Patentinhaber: **Siemens Aktiengesellschaft**
**80333 München (DE)**

(72) Erfinder:
• **HILD, Thomas**
**56414 Wallmerod (DE)**
• **KERN, Stefan**
**60431 Frankfurt am Main (DE)**

(74) Vertreter: **Siemens Patent Attorneys**
**Postfach 22 16 34**
**80506 München (DE)**

(56) Entgegenhaltungen:
WO-A1-2018/108828    DE-A1- 2 409 595
DE-A1- 4 426 699    DE-T2- 60 309 277
DE-U1- 9 412 169    US-A- 5 053 915
US-A1- 2019 234 995

**Beschreibung**

Die Erfindung bezieht sich auf eine Feldsondenkombination zur Verwendung bei Mittel- und Hochspannungen, eine Durchführung für Mittel- und Hochspannungsschaltanlagen mit einer oder mehr solcher Feldsondenkombinationen und Schaltanlagen mit einer oder mehr solchen Durchführungen.

Konventionelle Strom- & Spannungswandler transferieren tausende Volts oder tausende Ampere aus den Mittelspannungs-Verteilnetzen auf einfacher zu messende Größenordnungen herunter. Diese konventionellen Messwandler sind aber nur für die Grundfrequenz von 50 oder 60 Hz ausgelegt und geprüft. Die zulässigen Betrags- und Winkelfehler gelten nur für ein enges Frequenzband um die Nennfrequenz von 50Hz bzw. 60Hz herum. Insbesondere für konventionelle induktive Strom- und Spannungswandler mit Eisenkern und Kupferwicklung ist bekannt, dass diese zusätzliche höhere Frequenzen nur sehr unzureichend übertragen und sich durch Resonanzverstärkung oder Dämpfung sehr hohe Messfehler ergeben.

Da aber gerade auch höher frequente Anteile Aufschluss über den Zustand eines Versorgungs- oder Verteilnetzes geben, sind kapazitive Spannungsteiler von Interesse.

Alternativ könnte eine Feldsonde eines kapazitiven Spannungsteilers verwendet werden, beispielsweise aus einem Streckmetall oder einem leitfähigen Kunststoff hergestellt. Neben Messgeräten werden zumeist sogenannte Spannungsanzeiger an solche Feldsonden angeschlossen, die u.a. zum Anzeigen der Spannungsfreiheit vielfach normativ notwendig sind.

Zur Spannungsmessung hat sich Streckmetall durchgesetzt, da eine Feldsonde aus Streckmetall sehr dünnwandig - ca. 0,5mm - ausgeführt werden kann und im Vergleich zu einem leitfähigen Kunststoff keine Entformschrägen benötigt. Auch Wandstärken kleiner 1mm sind kein Problem. Ebenfalls besitzt eine Feldsonde z.B. aus Edelstahl gefertigt, eine sehr gute Haftung ans Gießharz. Um die Spannungsfestigkeit zwischen einer Messfeldsonde und einer geerdeten zweiten Feldsonde zu gewährleisten, ist ein bestimmter Abstand je nach Spannungspegel erforderlich. Ebenso müssen Formabweichungen der flexiblen Feldsonde aus Streckmetall berücksichtigt werden sowie Toleranzen, die sich durch die Positionierung im Gießharzwerkzeug ergeben. Hierdurch benötigen die kapazitiven Spannungsteiler inklusive Schirmung einen radialen Bauraum von > 2mm. Üblich sind in der Mittelspannung bis 40,5kV circa 5mm. Die 2x 5mm für die Spannungsmessung erfordern, dass der Querschnitt der Hauptstrombahn im Bereich der Feldsonde eingeschnürt werden muss. Bei einigen Durchführungen ist es wegen der Normungen daher bisher nur möglich eine Lösung für Primärnennströme von 630A anzubieten, für Primärströme mit 1250A oder mehr sind keine auf dieser Technologie basierenden Lösungen bekannt, da die Einschnürung und die aus den Einschnürungen resultierenden Verlustleistungen unter Beibehaltung marktüblicher Feldbreiten nicht möglich ist.

Aus dem Stand der Technik sind Strom- und Spannungswandler bekannt, die aus einer metallkaschierten Leiterplatte gebildet werden. Die Offenlegungsschrift der DE2409595 offenbart eine solche Anordnung.

Aus der DE 94 12 169 U1 ist eine Zentriervorrichtung für die Herstellung eines Spannungswandler bekannt, wobei der Spannungswandler mit einem hohlzylindrischen Trägerkörper gebildet ist.

Die DE 603 09 277 T2 offenbart einen zylindrischen Kondensator mit gedruckter Schaltung.

Weiter ist aus der DE 44 26 699 A1 ein Spannungswandler mit einer inneren und einer äußeren Elektrode bekannt.

Aus der US 5 053 915 A ist ein kapazitiver Sensor für eine Metall geschottete Anlage.

Die US 2019/234995 A1 offenbart einen rohrförmigen kapazitiven Spannungssensor.

Weiter offenbart die WO 2018/108828 A1 offenbart eine Messdurchführung mit einem röhrenförmigen Aufbau.

Problematisch bei einem solchen kapazitiven Spannungsteiler ist, dass die um den Hauptleiter radial angeordnete Feldsonde immer einen bestimmten Abstand zum Hauptleiter aufweisen muss, um die Spannungsfestigkeit den unter Hochspannung stehenden Hauptleiter zu gewährleisten. Die elektrische Feldstärke darf einen vom Dielektrikum materialabhängigen Grenzwert nicht überschreiten.

Auch schwankt die Permittivität - Epsilon r - vom Dielektrikum in Abhängigkeit von Temperatur und Feuchtigkeitsgehalt des Dielektrikums, im Beispiel der DE2409595 des SF6. Hierdurch schwankt auch das Messergebnis und die Messgenauigkeit wird herabgesetzt.

Eins der zu lösenden Probleme ist die Messgenauigkeit zu erhöhen.

Weiter sind Abnehmer von Schaltanlagen sehr preissensitiv und der Materialeinsatz trägt nicht unwesentlich zum Preis einer Schaltanlage bei.

Daher ist ein zu lösendes Problem auch, eine Feldsonde mit geringem Materialeinsatz bereitzustellen.

Weiter stellt sich das Problem, dass Schaltanlagen neben veränderlichen elektromagnetischen Feldern auch anderen veränderlichen Randbedingungen, wie beispielsweise Temperaturänderungen, ausgesetzt sind.

Ein zu lösendes Problem ist daher auch, die Feldsonde möglichst vielfältig gegen äußere Störeinflüsse, insbesondere veränderliche Störeinflüsse abzuschirmen, bzw. den Einfluss der Störeinflüsse zu reduzieren.

Trotz aller Maßnahmen darf sich dabei die Feldbreite nicht wesentlich vergrößern, insbesondere bei Mittelspannungsanlagen nicht vergrößern.

Bei allen diesen Problemen bleibt zu beachten, dass bei der Verwendung von einer Feldsonde und einer geerdeten Feldsonde immer ein Mindestabstand einzuhalten ist und dass Erwärmungsgrenzen, insbesondere an Kontaktstellen, eingehalten werden müssen, was sich in den beiden genannten Fällen auch in entsprechenden Normungen wiederfindet.

Aufgabe der Erfindung ist es daher, eine verbesserte Feldsondenkombination, eine verbesserte Durchführung mit mindestens einer solchen Feldsondenkombination und eine Schaltanlage mit einer oder mehreren solcher Durchführung mit mindestens einer solchen Feldsondenkombination bereitzustellen.

Gelöst wird die Aufgabe durch die Merkmale des unabhängigen Anspruchs 1 und der von diesem unabhängigen Anspruch abhängigen Ansprüche.

Ein Ausführungsbeispiel bezieht sich auf eine Feldsondenkombination zur Verwendung bei Mittel- und Hochspannungen, mit einer ersten Feldsonde und einer zweiten Feldsonde, wobei die erste Feldsonde und die zweite Feldsonde durch auf einem Isolator aufgebrachte erste leitende Feldsondenschicht für die erste Feldsonde und durch auf den Isolator aufgebrachte zweite leitende Feldsondenschicht für die zweite Feldsonde gebildet wird, wobei der Isolator die Form eines Hohlzylinders, oder eines parallel zu einer Symmetrieachse der Feldsondenkombination geschlitzten Hohlzylinders aufweist,

> wobei der Isolator senkrecht zu der Symmetrieachse, also in radialer Richtung, eine Isolatordicke aufweist, die die erste leitende Feldsondenschicht von der zweiten leitende Feldsondenschicht trennt,
> wobei die erste leitende Feldsondenschicht auf einer radial in das Innere des Hohlzylinders weisenden ersten Seite des Isolators angeordnet ist und die zweite leitende Feldsondenschicht auf einer auf dem Hohlzylinder radial nach Außen weisenden zweiten Seite des Isolators angeordnet ist,
> wobei die erste leitende Feldsondenschicht erste Kontaktierungsmittel und die zweite leitende Feldsondenschicht zweite Kontaktierungsmittel aufweisen.

Im Lichte dieser Offenbarung soll die Formulierung Hohlzylinder oder Hohlzylinderform oder hohlzylinderförmig auch immer die Form des geschlitzten Hohlzylinders umfassen, insbesondere auch einen vollständig geschlitzten Hohlzylinder, also einen Hohlzylinder, bei dem ein durchgehender Abschnitt der Mantelfläche parallel zur Symmetrieachse der Feldsondenkombination fehlt. Der Begriff leitend ist im Lichte dieser Offenbarung auf elektrisch leitend und der Begriff isolierend, isoliert oder Isolator auf elektrisch isolierend bezogen.

Die Kombination aus einem Isolator, insbesondere einem flexiblen Isolator, mit zwei Feldsonden ermöglicht insbesondere eine genaue Positionierbarkeit und Ausrichtbarkeit, bei einem fixen Isolationsabstand zwischen den Feldsonden.

Vorteilhaft ist auch, dass bei dieser Bauform nur ein Bauteil, die Feldsondenkombination, umgossen oder umspritzt werden muss, was den Produktionsaufwand für Durchführungen mit einer solchen Feldsondenkombination verringert.

Weiter stützt eine auf dem Isolator aufgebrachte Stützstruktur die Feldsondenkombination in der Beibehaltung der Hohlzylinderform. Stützen bezieht sich hier insbesondere auf ein Versteifen der ansonsten flexiblen Feldsondenkombination.

Weiter ist die Stützstruktur aus einem leitenden Kunststoff gebildet und die Stützstruktur ist umlaufend an einem offenen Rand oder an beiden offenen Rändern des Hohlzylinders des Isolators angeordnet.

Bevorzugt wird, dass die Feldsondenkombination in Kombination mit einem unter Mittel- oder Hochspannung stehenden Primärleiter einer Durchführung einen kapazitiven Spannungsteiler bildet, sodass durch Erdung des erste Kontaktierungsmittel am zweiten Kontaktierungsmittel eine für Personen ungefährliche und messbare Spannung anliegt.

Auch wird bevorzugt, dass der Isolator mit der aufgebrachten ersten Feldsonde und zweiten Feldsonde flexibel ausgebildet ist.

Flexibel im Sinne dieser Offenbarung sind Strukturen, die beweglich sind, sich also durch Krafteinwirkung reversibel verformen lassen, also insbesondere nicht starr sind. Solche Strukturen können durch weitere Maßnahmen, Bauteile, versteift, verstärkt oder gefestigt werden, so dass diese Strukturen dann weniger flexibel oder starr sind.

Bevorzugt wird dabei, dass die erste leitende Feldsondenschicht auf der Innenseite des hohlzylinderförmigen Isolators angeordnet ist und die zweite leitende Feldsondenschicht auf der Außenseite des hohlzylinderförmigen Isolators angeordnet ist.

Bevorzugt wird, dass die Stützstruktur umlaufend an einem offenen Rand des Hohlzylinders des Isolators angeordnet ist.

Insbesondere wird bevorzugt, dass die Stützstruktur derart umlaufend an einem offenen Rand des Hohlzylinders des Isolators angeordnet ist, dass die Stützstruktur die erste Feldsonde nicht berührt und/oder die Stützstruktur die zweite Feldsonde nicht berührt, insbesondere ist ein ausreichender isolierender Abstand zwischen der ersten leitenden Feldsondenschicht und der Stützstruktur und/oder der zweiten leitenden Feldsondenschicht und der Stützstruktur vorgesehen.

Die Stützstruktur ist aus einem leitenden Kunststoff gebildet und die Stützstruktur ist umlaufend an einem offenen Rand oder an beiden offenen Rändern des Hohlzylinders des Isolators angeordnet. Besonders bevorzugt wird in diesem Zusammenhang, dass die Stützstruktur aus dem leitenden Kunststoff weiter als Steuerelektrode ausgebildet ist. Die Ausbildung als Steuerelektrode erlaubt insbesondere auch eine Reduzierung des Abstandes der Feldsondenkombination vom Primärleiter, dessen elektrische Felder detektiert werden sollen. Ist die Steuerelektrode auf Erdpotential vorgesehen, so kann die Steuerelektode elektrisch leitend mit der zweiten leitenden Feldsondenschicht verbunden sein oder über einen eigenen Erdanschluss verfügen, ist die Steuerelektrode auf einem Zwischenpotential vorgesehen so muss die Steuerelektrode elektrisch ausreichend von der ersten leitenden Feldsondenschicht und/oder der zweiten leitenden Feldsondenschicht isoliert sein.

Besonders bevorzugt wird, dass die Stützstruktur aus einem leitenden Kunststoff gebildet ist und die Stützstruktur umlaufend an einem offenen Rand oder an beiden offenen Rändern des Hohlzylinders des Isolators angeordnet ist und die erste leitende Feldsondenschicht an diesem offenen Rand oder an diesen beiden offenen Rändern einen Stützstukturkontaktierungsbereich - insbesondere einen vergoldeten oder versilberten Stützstukturkontaktierungsbereich -, vorzugsweise einen durchgehenden oder unterbrochenen oder teilweise unterbrochenen Streifen parallel zum einem offenen Rand oder parallel zu beiden offenen Rändern des Hohlzylinders des Isolators ausgebildeten Stützstukturkontaktierungsbereich, der eine elektrische Kontaktierung zwischen der ersten leitenden Feldsondenschicht und der Stützstruktur ermöglicht. Insbesondere wird bevorzugt, dass der als Streifen ausgebildete Stützstukturkontaktierungsbereich eine Breite von 0,2mm bis 5,0mm, weiter bevorzugt eine Breite 0,3mm bis 2mm, insbesondere bevorzugt eine Breite 0,5mm bis 1mm aufweist.

Auch wird bevorzugt, dass sowohl das erste Kontaktierungsmittel, als auch das zweite Kontaktierungsmittel auf der zweiten Seite des Hohlzylinders des Isolators angeordnet sind, wobei eine elektrisch leitende Verbindung zwischen der ersten leitenden Feldsondenschicht und dem Kontaktierungsmittel durch ein Durchgangsloch im Isolator geführt ist. Diese Anordnung erlaubt eine vereinfachte Kontaktierung, insbesondere über eine Außenmantelfläche des Hohlzylinders der Feldsondenkombination. Auch kommt es durch die Anschlussleitungen auf der Außenmantelfläche des Hohlzylinders der Feldsondenkombination zu keiner Beeinflussung des elektrischen Feldes zwischen dem unter Spannung, insbesondere unter Mittel- oder Hochspannung, stehenden Hauptleiter, Primärleiters, und der zweiten, insbesondere inneren, leitenden Feldsondenschicht.

Bevorzugt wird auch, dass das erste Kontaktierungsmittel und das zweite Kontaktierungsmittel jeweils als Lötpad ausgebildet sind. Diese Ausbildung erlaubt eine einfache Kontaktierung, insbesondere eine automatisierte Herstellung der Kontaktierung mit elektrischen Leitungen.

Besonders bevorzugt wird, dass das erste Kontaktierungsmittel und das zweite Kontaktierungsmittel jeweils als vergoldetes oder versilbertes Pad ausgebildet sind. Diese Ausbildung erlaubt eine einfache Kontaktierung, insbesondere an ein Anschlusselement zur Erdung und zu Signalweitergabe.

Insbesondere wird weiter bevorzugt, dass die Kontaktierungsmittel mit einer weiteren Leiterplatte verbunden sind, die anstelle von elektrischen Leitungen die Kontaktierung des Feldsondenkombination realisiert. Besonders bevorzugt wird, dabei, dass die weitere Leiterplatte eine flexible, also reversibel biegbare, Leiterplatte, ist. Insbesondere wird auch bevorzugt, dass auf der weiteren Leiterplatte oder weiteren flexiblen Leiterplatte, ein Stecker oder eine Buchse zur Kontaktierung der Feldsondenkombination angeordnet sind.

Weiter wird bevorzugt, dass der Isolator senkrecht zu der Symmetrieachse, also in radialer Richtung der Hohlzylinderform der Feldsondenkombination, eine Isolatordicke aufweist, die zwischen 0,001mm und 0,15mm, insbesondere bevorzugt 0,04mm bis 0,08mm beträgt und eine Spannungsfestigkeit von 10V/$\mu$m bis 7kV/um, insbesondere bevorzugt von 10V/$\mu$m bis 250V/$\mu$m oder 150V/$\mu$m bis 7kV/$\mu$m, aufweist.

Insbesondere wird bevorzugt, dass der Isolator senkrecht zu der Symmetrieachse, also in radialer Richtung der Hohlzylinderform der Feldsondenkombination, eine Isolatordicke aufweist, die 0,05mm $\pm$0,005mm beträgt und eine Spannungsfestigkeit von 250V/$\mu$m $\pm$5V/$\mu$m aufweist. Bei solchen geringen Isolatordicken, die unter anderem einen kleinen Bauraum ermöglichen, bestehen hohe Anforderungen an die Gleichmäßigkeit der Dicke des Isolators.

Auch wird bevorzugt, dass die Feldsondenkombination aus einen an zwei Seiten teilweise mit Kupfer beschichteten PCB, Leiterplatten, insbesondere einem an zwei Seiten teilweise mit Kupfer beschichteten und flexibel ausgebildeten PCB, Leiterplatte, gebildet wird. Solche beidseitig beschichteten PCB's bieten hohe Homogenitäten in Bezug auf die Dicken der einzelnen Schichten und sind daher besonders gut geeignet. Unter flexibel soll im Rahmen dieser Offenbarung verstanden werden, dass die Leiterplatten reversibel biegbar sind, also keinen Schaden beim Biegen nehmen.

Bevorzugt wird auch, dass der Isolator aus vorimprägnierten Fasern, insbesondere ein FR4 Material, gebildet ist.

Bevorzugt wird auch, dass der Isolator aus einer Polyimid Folie gebildet ist.

Auch wird bevorzugt, dass die erste leitende Feldsondenschicht und die zweite leitende Feldsondenschicht aus Kupfer gebildet werden, wobei die erste leitende Feldsondenschicht und die zweite leitende Feldsondenschicht jeweils eine Dicke in radialer Richtung des Hohlzylinders des Isolators zwischen 0,017mm und 0,105mm aufweisen.

Insbesondere wird bevorzugt, dass die erste leitende Feldsondenschicht und die zweite leitende Feldsondenschicht aus Kupferschichten gebildet werden, wobei die erste leitende Feldsondenschicht und die zweite leitende Feldsondenschicht jeweils eine Dicke - in radialer Richtung des Hohlzylinders des Isolators - von 0,025mm bis 0,045mm aufweisen, insbesondere eine Dicke in radialer Richtung des Hohlzylinders des Isolators von 0,035mm $\pm$0,005mm aufweisen.

Solche flexiblen PCBs mit einer Isolatordicke von 0,05mm $\pm$0,005mm und einer Spannungsfestigkeit von 250V/$\mu$m $\pm$5V/$\mu$m und mit Kupferschichten die eine Dicke von 0,035mm $\pm$0,005mm aufweisen, ermöglichen insbesondere in der Größe reduzierte Feldsondenkombinationen bei einer Eignung für Mittelspannungsanlagen mit einer Nennspannung von 40,5kV und mit einer maximalen Blitzstoßspannung von 200kV, insbesondere auch für 1250A Nennstrom.

Diese PCBs sind nicht nur überraschend gut geeignet, um auch bei Blitzstoßspannungen von 200kV auf dem Primärleiter, keine Überschläge, Durchschläge, durch den Isolator zwischen der ersten leitenden Feldsondenschicht und der zweiten leitenden Feldsondenschicht zuzulassen, sondern ermöglichen auch einen kompakten Aufbau, der kleiner bauende Durchführungen als herkömmlich erlaubt.

Bevorzugt wird auch, dass die Feldsondenkombination eine oder mehrere Vertiefungen und/oder Öffnungen, Nuten, parallel zu der Symmetrieachse des Hohlzylinders der Feldsondenkombination aufweist. Die Öffnungen und/oder Nuten, sind dabei derart angeordnet, dass an Rändern des Hohlzylinders jeweils ein Steg bestehen bleibt und eine ausreichende Isolierung zwischen der ersten leitenden Feldsondenschicht und der zweiten leitenden Feldsondenschicht gewährleitet ist.

Die Vertiefungen oder Schlitzungen bewirken, dass bei einem späteren Umgießen der Feldsondenkombination mit einem Gießharz, das Gießharz die Feldsondenkombination besser umfließen kann und so den Prozess des Eingießens in eine Durchführung verbessert. Zusätzlich dazu begünstigten diese Vertiefungen oder Schlitzungen die Formgebung, insbesondere die Formgebung durch Biegen aus einer Flachen Grundform in die Form eines Hohlzylinders oder geschlitzten Hohlzylinders.

Auch wird bevorzugt, dass Oberflächen der Feldsondenkombination, insbesondere die Oberflächen der ersten leitenden Feldsondenschicht und der zweiten leitenden Feldsondenschicht, derart oberflächenbehandelt ist, dass diese Oberflächen eine erhöhte Rauigkeit aufweisen, als ohne die Oberflächenbehandlung.

Eine solche erhöhte Rauigkeit führt zu einer besseren Haftung eines Gießharzes, mit dem die Feldsondenkombination vorteilhafter weise umgossen wird oder die Feldsondenkombination vorteilhafter weise umgießbar ist.

Insbesondere wird bevorzugt, dass die Oberflächenbehandlung in einer Auftragung einer Multibondbeschichtung gesteht, also einer Beschichtung, die die Haftungseigenschaften verbessert, insbesondere die Haftung von Kunststoffen, wie beispielsweise Gießharz.

Insbesondere wird auch bevorzugt, dass die erste leitende Feldsondenschicht und die zweite leitende Feldsondenschicht mit oder aus Kupfer gebildet sind und die Oberflächenbehandlung zumindest umfasst, dass auf den Oberflächen der ersten leitenden Feldsondenschicht und der zweiten leitenden Feldsondenschicht ein Kupfer(I)-Oxid und/oder Kupfer(II)-Oxid gebildet wird.

Bevorzugt wird auch, dass die Feldsondenkombination weiter zumindest einen oder mehr Temperatursensoren aufweist, wobei der Temperatursensor oder die Temperatursensoren die Temperatur der Feldsondenkombination messen, beziehungsweise die Temperatur der Feldsondenkombination derart messbar ist, und so ein Temperaturmesswert bestimmbar ist und der Temperaturmesswert zu einer Messwertkorrektur von gemessenen Spannungen mittels Temperaturkompensation heranziehbar ist.

Besonders bevorzugt wird, dass der oder die Temperatursensoren mit einem oder mehreren pt100 oder pt1000 SMD Bauteilen gebildet werden.

Auch wird bevorzugt, dass der Temperatursensor mittels eines, zweier oder mehrerer Lödpads kontaktierbar ist und/oder Kontaktpins aufweist.

Ein weiteres Ausführungsbeispiel bezieht sich auf eine Durchführung für Mittel- und Hochspannungsschaltanlagen mit einer oder mehr Feldsondenkombinationen nach einer oder mehreren der vorstehenden Ausführungen.

Insbesondere wird bevorzugt, dass die eine oder mehreren Feldsondenkombinationen von einem Kunststoff, insbesondere einem Gießharz, in der Durchführung um einen Primärleiter fixiert wird. Dazu wird die Feldsondenkombination derart um den Primärleiter angeordnet, dass der Primärleiter auf der Symmetrieachse der Hohlzylinderform der Feldsondenkombination angeordnet ist, insbesondere, dass eine Symmetrieachse des Primärleiters auf der oder parallel zu der Symmetrieachse der Hohlzylinderform der Feldsondenkombination angeordnet ist. Diese Anordnung ist dann, mit gegebenenfalls weiteren Komponenten, wie Zuleitungen, Dichtungen, Flanschen und ähnlichem, mit einem Kunststoff, insbesondere einem Gießharz, umgossen.

Auch wird bevorzugt, dass zwei oder mehr Feldsondenkombinationen hintereinander in der Durchführung angeordnet sind. Eine solche Kombination bietet eine erhöhten Ausfallschutz durch die redundante Ausführung oder aber zwei oder mehr unabhängige Messsysteme.

Bevorzugt wird auch, dass die Durchführung einen oder mehr Temperatursensoren aufweist, der oder die insbesondere mit einem Messgerät zur Bestimmung anliegender Spannungen verbindbar sind, so dass eine Temperatur der Durchführung bestimmbar ist und die Temperatur der Durchführung zur Messwertkorrektur von gemessenen Spannungen mittels Temperaturkompensation herangezogen wird. Besonders bevorzugt ist der oder sind die Temperatursensoren auf der Feldsondenkombination angeordnet und messen so die Temperatur der Feldsondenkombination und damit die Temperatur der Durchführung an der Feldsondenkombination. Alternativ wird bevorzugt, dass der oder die Temperatursensoren in räumlicher Nähe zu der oder auf der Feldsondenkombination angeordnet sind und so die Temperatur der Durchführung an der Feldsondenkombination bestimmen. In räumlicher Nähe soll hier zwischen 0,2mm und 5mm Abstand zur Feldsondenkombination bedeuten.

Besonders bevorzugt wird, dass der oder die Temperatursensoren mit einem oder mehreren pt100 oder pt1000 SMD Bauteilen gebildet werden.

Ein weiteres Ausführungsbeispiel bezieht sich auf eine Schaltanlage für Mittel- und Hochspannungsschaltanlagen mit einer oder mehr Durchführungen nach einer oder mehreren der vorstehenden Ausführungen. Die Durchführungen weisen eine oder mehr Feldsondenkombinationen nach einer oder mehreren der vorstehenden Ausführungen auf.

Bevorzugt wird auch, dass zumindest eine Durchführung einen oder mehr Temperatursensoren aufweist, der oder die insbesondere mit einem Messgerät, wie einem Messgerät der Schaltanlage, zur Bestimmung anliegender Spannungen verbindbar oder verbunden ist, so dass eine Temperatur der Durchführung und damit der Feldsondenkombination bestimmbar ist und die Temperatur der Durchführung zur Messwertkorrektur von gemessenen Spannungen mittels Temperaturkompensation herangezogen wird. Besonders bevorzugt ist der Temperatursensor oder sind die Temperatursensoren auf der Feldsondenkombination angeordnet und messen so die Temperatur der Feldsondenkombination und damit der Durchführung an der Feldsondenkombination.

Besonders bevorzugt wird, dass der oder die Temperatursensoren mit einem oder mehreren pt100 oder pt1000 SMD Bauteilen gebildet werden.

Die vorstehenden Ausführungen sind vielfach miteinander kombinierbar, sofern diese keine Alternativen darstellen.

Im Folgenden werden die Lösungen und Ausführungen anhand von Figuren detaillierter erläutert, wobei die möglichen Ausführungen nicht auf die in den Figuren beschriebenen Merkmale begrenzt sind.

Figur 1:     Schematische Darstellung einer Schaltanlage;

Figur 2:     Schematischer Längsschnitt durch eine Durchführung mit einer erfindungsgemäßen Feldsondenkombination;

Figur 3:     Schematische Schnittdarstellung einer erfindungsgemäßen Feldsondenkombination in einem isolierenden Kunststoff;

Figur 4:     Schematische Darstellung einer erfindungsgemäßen Feldsondenkombination in einem isolierenden Kunststoff mit einem Primärleiter;

Figur 5:     Ersatzschaltbild einer erfindungsgemäßen Feldsondenkombination.

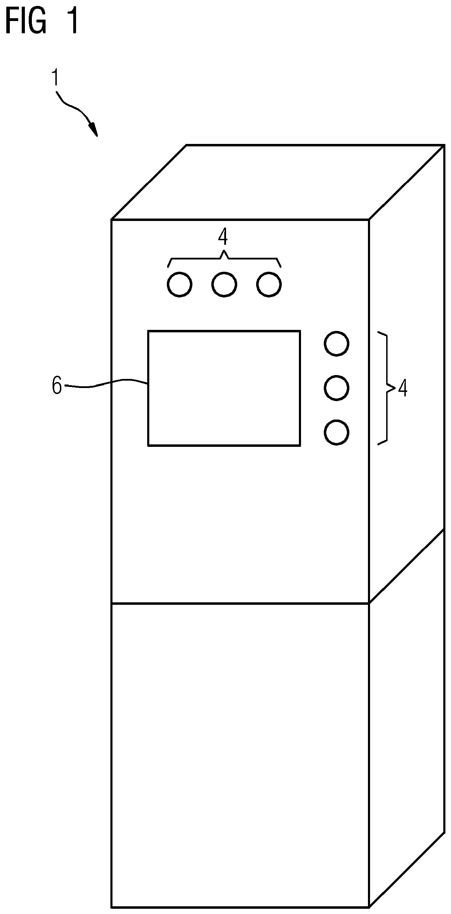

Die Figur 1 zeigt eine schematische Darstellung einer Schaltanlage 1 mit Anzeigeinstrumenten 4 und einem Bedienfeld 6 für die Bedienung der Schaltanlage 1. Das Bedienfeld 6 kann dabei virtuell, zum Beispiel in Form eines Touchscreens, oder aber mit mechanischen und/oder elektrischen Schaltelementen ausgeführt sein. Die Anzeigeinstrumente 4 sind als analoge oder digitale Anzeigeinstrumente 4 ausgestaltet. Das jeweilige Anzeigeinstrument 4 zeigt beispielsweise einen Gasdruck, eine Spannung, einen Strom, einen Schaltzustand, eine Temperatur oder einen Schaltanlagenzustand an.

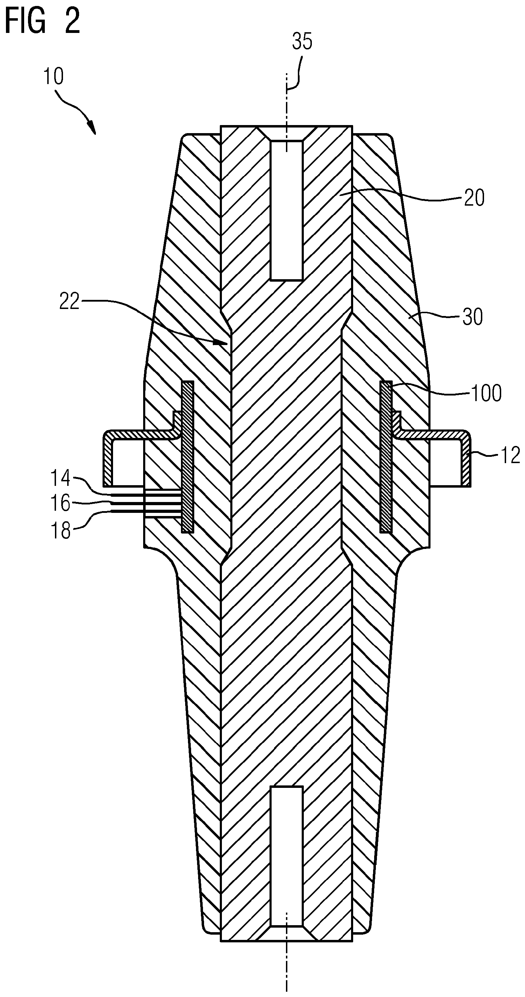

Die Figur 2 zeigt einen schematischen Längsschnitt durch eine erfindungsgemäße Durchführung 10 mit einer erfindungsgemäßen Feldsondenkombination 100. Die Durchführung 10 weist einen Primärleiter 20 auf, der sich entlang einer Längsachse 35 der Durchführung 10 erstreckt. In einer bevorzugten Ausführungsform weist der Primärleiter 22 im Bereich der Feldsondenkombination 100 eine Einschnürung 22 auf.

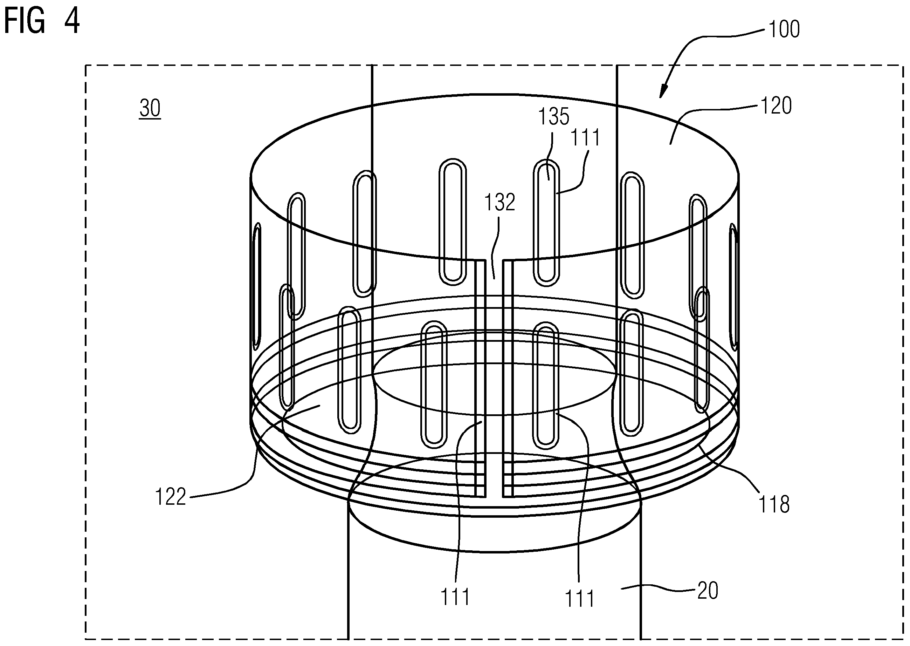

Um den Primärleiter 20 angeordnet ist die Feldsondenkombination 100, die optional mit einem Durchführungsanschlussflansch 12 verbunden ist. Optional ist der Durchführungsanschlussflansch 12 elektrisch leitend mit einer zweiten Feldsonde 112, hier nicht bezeichnet, verbunden. Der Primärleiter 20, die Feldsondenkombination 100 und der Durchführungsanschlussflansch 12 sind teilweise mit einem elektrisch isolierenden Kunststoff 30, insbesondere einem Gießharz 30, umgossen. Dabei sind die auf der Längsachse 35 liegenden Enden des Primärleiter 20 nicht mit dem elektrisch isolierenden Kunststoff 30 bedeckt. Auch sind Teile des optionalen Durchführungsanschlussflansches 12 nicht mit dem elektrisch isolierenden Kunststoff 30 bedeckt, um ein Einschweißen zu ermöglichen. Weiter ist ein Bereich um die Feldsondenkombination 100 nicht mit dem elektrisch isolierenden Kunststoff 30 bedeckt, um mit Anschlussleitungen 14,16,18 die hier nicht gezeigten Kontaktierungsmittel 121, 123 und/oder einem Temperatursensor 130 elektrisch leitend zu verbinden. Optional sind die Anschlussleitungen 14,16,18 dabei als elektrisch leitende Metallpins ausgeführt, so dass ein Stecker in die aus Anschlussleitungen 14,16,18 und dem elektrisch isolierenden Kunststoff 30 gebildete Buche aufnehmbar ist. Der optionale Durchführungsanschlussflansch 12 kann in einer weiter optionalen Ausführung die Funktion der optionalen, hier nicht gezeigten, Stützstruktur 118 übernehmen, siehe Figur 4.

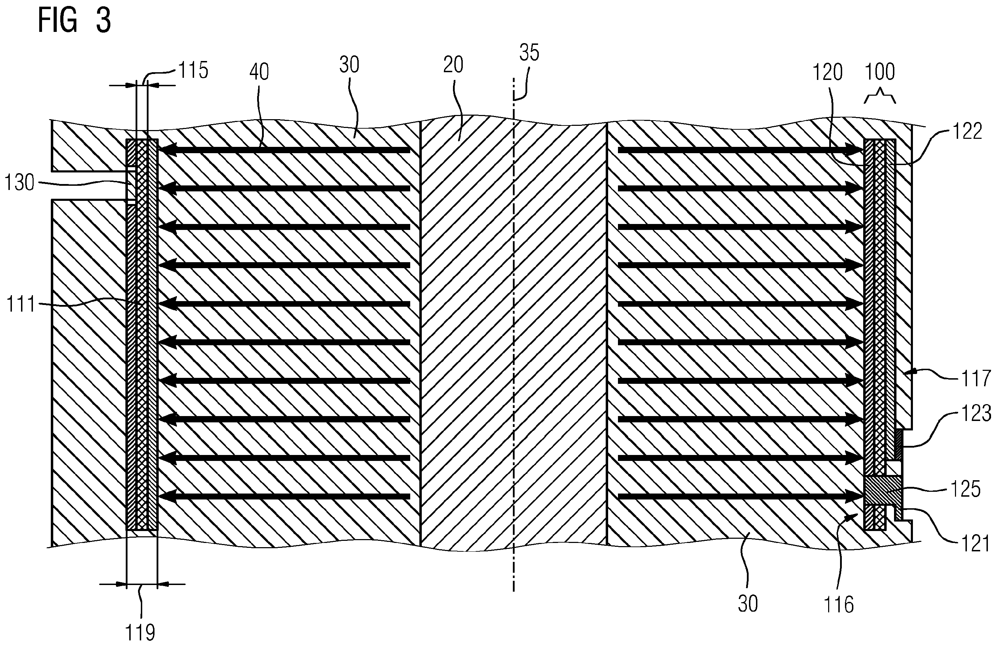

Die Figur 3 zeigt eine schematische Schnittdarstellung einer erfindungsgemäßen Feldsondenkombination 100 in einem isolierenden Kunststoff 30. Mittig in dem Kunststoff 30 und der Feldsondenkombination 100 angeordnet ist der Primärleiter 20, der sich entlang einer Längsachse 35 erstreckt.

Die Feldsondenkombination 100 wird hier beispielsweise mit einem Isolator 111, beispielsweise einem flexiblen Isolator 111, gebildet, auf dem eine erste leitende Feldsondenschicht 120 als eine erste Feldsonde 110, hier nicht bezeichnet, und eine zweite leitende Feldsondenschicht 122 als eine zweite Feldsonde 112, hier nicht bezeichnet, angeordnet ist. Die Isolator 111 weist eine Hohlzylinderform auf und die erste leitende Feldsondenschicht 120 ist auf der der Längsachse 35 zugewandten Seite, der Innenseite, des Hohlzylinders angeordnet. Diese Innenseite des Hohlzylinders wird auch als nach Innen weisende erste Seite 116 des Hohlzylinders des Isolators 111 bezeichnet. Die zweite leitende Feldsondenschicht 122 ist auf der der Längsachse 35 abgewandten Seite, der Außenseite, des in Hohlzylinderform vorliegenden Isolators 111 angeordnet. Diese Außenseite des Hohlzylinders wird auch als nach außen weisende zweite Seite 117 des Hohlzylinders des Isolators 111 bezeichnet.

In der hier gezeigten bevorzugten Ausführung ist ein zweites Kontaktierungsmittel 123 an der zweiten leitenden Feldsondenschicht 122 angeordnet, dass durch eine Ausnehmung in dem isolierenden Kunststoff 30 elektrisch leitend kontaktierbar ist. Weiter ist in einer vorteilhaften Ausführung in dem Isolator 111 ein elektrisch leitender Durchgang 125, also eine Durchkontaktierung oder auch vertical interconnect access, kurz "VIA", vorgesehen. Mittels dieses elektrisch leitenden Durchgangs 125 wird ein erstes Kontaktierungsmittel 121 mit der ersten leitenden Feldsondenschicht 120 elektrisch verbunden und auf der Außenseite des Isolators 111, elektrisch von der zweiten leitenden Feldsondenschicht 122 isoliert, angeordnet. Durch diese Anordnung sind sowohl das erste Kontaktierungsmittel 121 und das zweite Kontaktierungsmittel 123 durch eine Ausnehmung in dem isolierenden Kunststoff 30 elektrisch leitend von der Außenseite der Feldsondenkombination 100 kontaktierbar. Gleiches gilt, wenn alternativ zu Leitungen von den ersten Kontaktierungsmitteln 121 und den zweiten Kontaktierungsmitteln 123 ein oder mehr weitere flexible Leiterplatten wegführen, die bevorzugt selbst eine Buchse oder einen Stecker aufweisen. Die weitere oder die weiteren flexiblen Leiterplatten können dabei an durch Anpressen, Ankleben, Anlöten, Anschrauben, Anklemmen oder andere Befestigungsmaßnahmen mit dem ersten Kontaktierungsmittel 121 und dem zweiten Kontaktierungsmittel 123 jeweils elektrisch leitend verbunden werden.

Weiter ist vorteilhaft, dass die Feldsondenkombination 100 einen Temperatursensor 130 vorsieht, oder zumindest ein Temperatursensor 130 in räumlicher Nähe, z.B. im Abstand zwischen 0,2mm und 5mm, zur oder auf der Feldsondenkombination 100 angeordnet ist. In dem gezeigten Beispiel ist der Temperatursensor 130 auf dem Isolator 111 angeordnet und eine Ausnehmung im dem elektrische isolierenden Kunststoff 30 ermöglicht eine Kontaktierung des Temperatursensors 130 von der Außenseite der Feldsondenkombination 100. In einem nicht gezeigten Beispiel ist der Temperatursensor 130 derart angeordnet, dass der Temperatursensor 130 durch dieselbe Ausnehmung im elektrische isolierenden Kunststoff 30 kontaktierbar ist, wie das erste Kontaktierungsmittel 121 und das zweite Kontaktierungsmittel 123. Eine solche Anordnung ist in Figur 2 angedeutet. Der Isolator 111 weist eine Isolatordicke 115 auf, die bevorzugt zwischen 0,001mm und 0,15 mm, besonders bevorzugt 0,05mm, beträgt. Der Isolator 111 weist dabei bevorzugt Spannungsfestigkeit von $10V/\mu m$ bis $7kV/\mu m$, besonders bevorzugt $250V/\mu m \pm 5V/\mu m$, auf.

In einem weiteren nicht gezeigten Beispiel ist der Temperatursensor 130 als SMD Temperatursensor ausgeführt und wird auf einem, zwei oder mehr Lötpads auf dem Isolator 111 befestigt und über diese Lötpads kontaktiert. Die Leitungsführung nach außen erfolgt dann vorzugsweise über weitere Kontaktirungsmittel, weiter bevorzugt weitere Kontaktierungsmittel in räumlicher Nähe, bevorzugt in einem Abstand von 0,5mm bis 15,0mm, zum ersten Kontaktierungsmittel und/oder zweiten Kontaktierungsmittel.

Die Gesamtdicke 119 aus der ersten leitenden Feldsondenschicht 120 und zweiten leitenden Feldsondenschicht 122 und der Dicke des Isolators 115 beträgt bevorzugt 0,09mm bis 0,17mm, besonders bevorzugt $0,12mm \pm 0,005mm$.

Das radiale elektrische Feld 40 um den Primärleiter 20 wird durch die Pfeile symbolisiert.

Die Figur 4 zeigt eine schematische und perspektivische Darstellung einer erfindungsgemäßen Feldsondenkombination 100 in einem isolierenden Kunststoff 30 mit einem Primärleiter 20. Nicht gezeigt sind hier Ausnehmungen im Kunststoff, der Temperatursensor, Kontaktmittel oder Anschlussleitungen.

Der Primärleiter 20 ist mittig in der Feldsondenkombination 100 angeordnet und beides zusammen ist von isolierendem Kunststoff 30 umgeben, vergleiche hierzu Figur 2. Die Feldsondenkombination 100 weist optional eine Stützstruktur 118 auf, die die Feldsondenkombination 100 zusätzlich zu ihrer Eigenstabilität in der Hohlzylinderform hält.

Die hier gezeigte Feldsondenkombination 100 weist eine durchgehende Schlitzung 132 im Hohlzylinder des Isolators 111 auf. Weiter sind in der Feldsondenkombination 100 optionale Schlitzungen 135 vorhanden, die ein Umgießen der Anordnung erleichtern. Um das Risiko von leitenden Brücken oder Kriechströmen oder Überschlägen zwischen der ersten leitenden Feldsondenschicht 120 und der zweiten leitenden Feldsondenschicht 122 zu verhindern, ist hier optional die Schlitzung im Isolator 111 flächenmäßig kleiner als die Schlitzung in der ersten leitenden Feldsondenschicht 120 und der zweiten leitenden Feldsondenschicht 122, so dass der Isolator 111 in die Schlitzung hereinragt.

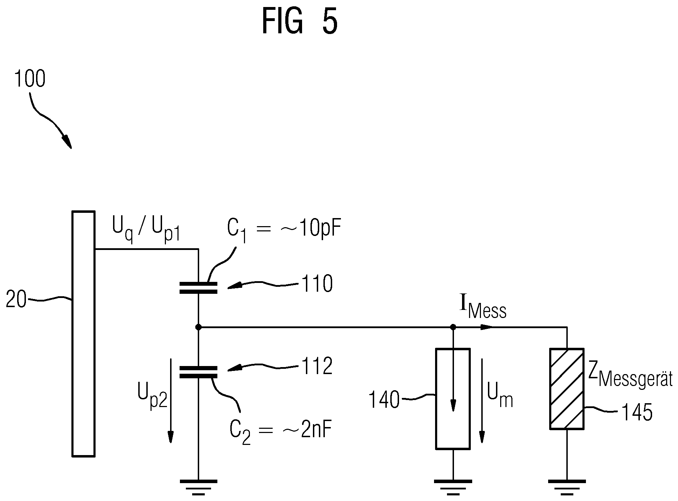

Die Figur 5 zeigt ein Ersatzschaltbild einer erfindungsgemä-ßen Feldsondenkombination 100 in einer nicht gezeigten Durchführung 10. Die Feldsondenkombination 100 weist eine erste Feldsonde 110 auf, die um den Primärleiter 20 herum isoliert angeordnet ist. Die Isolation wird durch die Beabstandung und das Verfüllen des Zwischenraums zwischen Feldsondenkombination 100 und Primärleiter 20 mit einem elektrisch isolierenden Kunststoff 30, hier nicht gezeigt, erreicht, wobei der isolierende Kunststoff 30 die Feldsondenkombination 100 auch zumindest teilweise umgibt. Diese elektrische Isolation des Primärleiters 20 von der ersten Feldsonde 110 bestimmt eine erste Kapazität $C_1$. Am Primärleiter liegt die Quellspannung $U_q$ oder $U_{p1}$ an. Die erste Kapazität C1 ergibt sich bei den üblichen Abständen und einem isolierenden Gießharz als isolierenden Kunststoff 30 zu etwa 10pF. Die erste Feldsonde 110 und die zweite Feldsonde 112 sind durch den Isolator 111 voneinander getrennt und bilden zusammen eine zweite Kapazität C2. Die zweite Feldsonde 112 ist geerdet, so dass sich ein kapazitiver Spannungsteiler aus C1 und C2 ergibt.

Durch eine bevorzugte Isolatordicke 115 von 0,05mm $\pm$ 0,005mm bei einem PI ist die Kapazität C2 von etwa 2nF (2000pF) bewust deutlich größer als die Kapazität C1 von etwa 10pF, die zusammen den kapazitiven Spannungsteiler bilden. Die Quellspannung $U_q$ oder $U_{p1}$ wird so auf eine geringere Spannung $U_m$ abgesenkt, die am Kontaktierungsmittel 121 abgreifbar und/oder messbar ist.

Durch die optionale Ausnehmung in dem isolierenden Kunststoff 30 kann das Kontaktierungsmittel 121 offenliegen. Durch die vorzugsweise Auslegung der Feldsondenkombination 100 kann am Kontaktierungsmittel 121 aber niemals eine unzulässig hohe personen-, bauteil- oder gerätegefährdende Spannung anliegen. Im Nennbetrieb mit der Nennspannung Up von etwa 40,5kV ergibt sich $U_{p2nenn}$ (Spannungsfall über die Kapazität C2 bei Nennspannung) zu

$$
\begin{aligned}
\texttt{U}_{\texttt{p2nenn}} \quad &= \quad \texttt{40,5kV * (C}_1\texttt{/(C}_1\texttt{+C}_2\texttt{))} \\
&= \quad \texttt{40,5kV * (10pF/(10pF + 2000pF))} \\
&= \quad \texttt{0,2kV}
\end{aligned}
$$

Gleichzeitig darf der Isolator 111 bei einer maximalen Blitzstoßspannung von 200kV (typisch für einen 40,5kV Mittelspannungssscshaltanlage) nicht durchschlagen.

Es ergibt sich $U_{p2max}$ (Spannungsabfall über die Kapazität C2 bei maximaler Blitzstoßspannung) zu

$$
\begin{aligned}
\texttt{U}_{\texttt{p2max}} \quad &= \quad \texttt{200kV * (C}_1\texttt{/(C}_1\texttt{+C}_2\texttt{))} \\
&= \quad \texttt{200kV * (10pF/(10pF + 2000pF))} \\
&= \quad \texttt{1kV}
\end{aligned}
$$

$U_{p2max}$ muss kleiner sein als die Durchschlagsfestigkeit des Isolators 111. Bei einer angenommenen Durchschlagsfestigkeit, beispielsweise von PI, Polyimid, von 250V/$\mu$m und einer Isolatordicke 115 von 0,05mm ist $U_{p2max}$ wie gefordert mit 1kV kleiner als die Durchschlagsfestigkeit von 12,5kV des Isolators 111.

Weiter zeigt die Figur 5 noch einen Überspannungsableiter 140 mit dem Spannungsabfall $U_m$ und den zum Messgerät 145 fließenden Strom $I_{Mess}$, wobei sowohl Messgerät 145 als auch Überspannungsableiter 140 geerdet sind. Das Messgerät weist eine Impedanz $Z_{Messgerät}$ auf.

Bezugszeichenliste

| 1   | Schaltanlage; |
| --- | --- |
| 4   | Anzeigeinstrumente der Schaltanlage 1; |
| 6   | Bedienfeld der Schaltanlage 1; |
| 10  | Durchführung für eine Schaltanlage 1; |
| 12  | Durchführungsanschlussflansch; |
| 14  | erste Thermoelementanschlussleitung; |
| 16  | zweite Thermoelementanschlussleitung; |
| 18  | Anschlussleitung für erste leitende Feldsondenschicht für die erste Feldsonde 110 |
| 20  | Primärleiter der Durchführung 10; |
| 22  | Einschnürung des Primärleiters 20 der Durchführung 10; |
| 30  | Kunststoff, insbesondere Gießharz; |
| 35  | Längsachse der Durchführung 10; |
| 40  | elektrisches Feld um den Primärleiter 10; |
| 100 | Feldsondenkombination; |

110     erste Feldsonde der Feldsondenkombination 100;

111     Isolator;

112     zweite Feldsonde der Feldsondenkombination 100;

115     Isolatordicke des Isolators 111;

116     nach Innen weisende erste Seite des Hohlzylinders des Isolators 111;

117     nach Außen weisende zweite Seite des Hohlzylinders des Isolators 111;

118     Stützstruktur;

119     Gesamtdicke der ersten und zweiten leitende Feldsondenschicht und der Dicke des Isolators;

120     erste leitende Feldsondenschicht für die erste Feldsonde 110;

121     erste Kontaktierungsmittel;

122     zweite leitende Feldsondenschicht für die zweite Feldsonde 112;

123     zweite Kontaktierungsmittel;

125     elektrisch leitfähiger Durchgang durch den Isolator 111;

130     Temperatursensor

132     durchgehende Schlitzung im Hohlzylinder des Isolators 111;

135     Schlitzung in der Feldsondenkombination 100;

140     Überspannungsableiter;

145     Messgerät.

**Patentansprüche**

1.   Feldsondenkombination (100) zur Verwendung bei Mittel- und Hochspannungen, mit einer ersten Feldsonde (110) und einer zweiten Feldsonde (112), wobei

die erste Feldsonde (110) und die zweite Feldsonde (112) durch auf einem Isolator (111) aufgebrachte erste leitende Feldsondenschicht (120) für die erste Feldsonde (110) und durch auf den Isolator (111) aufgebrachte zweite leitende Feldsondenschicht (122) für die zweite Feldsonde (112) gebildet wird,
wobei der Isolator (111) die Form
eines Hohlzylinders, oder
eines parallel zu einer Symmetrieachse (101) der Feldsondenkombination (100) geschlitzten Hohlzylinders aufweist,
wobei der Isolator (111) senkrecht zu der Symmetrieachse (101), also in radialer Richtung, eine Isolatordicke (115) aufweist, die die erste leitende Feldsondenschicht (120) von der zweiten leitende Feldsondenschicht (122) trennt,
wobei die erste leitende Feldsondenschicht (120) auf einer radial in das Innere des Hohlzylinders weisenden ersten Seite (116) des Isolators (111) angeordnet ist und die zweite leitende Feldsondenschicht (122) auf einer auf dem Hohlzylinder radial nach Außen weisenden zweiten Seite (117) des Isolators (111) angeordnet ist,
wobei die erste leitende Feldsondenschicht (120) erste Kontaktierungsmittel (121) und die zweite leitende Feldsondenschicht (122) zweite Kontaktierungsmittel (123) aufweisen, wobei
eine auf dem Isolator (111) aufgebrachte Stützstruktur (118) die Feldsondenkombination (100) in der Beibehaltung der Hohlzylinderform stützt
**dadurch gekennzeichnet , dass**
die Stützstruktur (118) aus einem leitenden Kunststoff gebildet ist und die Stützstruktur (118) umlaufend an einem offenen Rand des Hohlzylinders des Isolators (111) angeordnet ist.

2.   Feldsondenkombination (100) nach Anspruch 1,

**dadurch gekennzeichnet , dass** sowohl das erste Kontaktierungsmittel (121), als auch das zweite Kontaktierungsmittel (123) auf der zweiten Seite (117) des Hohlzylinders des Isolators (111) angeordnet sind,
wobei eine elektrisch leitende Verbindung zwischen der ersten leitenden Feldsondenschicht (120) und dem Kontaktierungsmittel (121) durch ein Durchgangsloch im Isolator (111) geführt ist.

3.   Feldsondenkombination (100) nach einem oder mehreren der vorstehenden Ansprüche,
**dadurch gekennzeichnet , dass**
das erste Kontaktierungsmittel (121) und das zweite Kontaktierungsmittel (123) jeweils als Lötpad ausgebildet sind.

4.   Feldsondenkombination (100) nach einem oder mehreren der vorstehenden Ansprüche,
**dadurch gekennzeichnet , dass**

der Isolator (111) senkrecht zu der Symmetrieachse (101), also in radialer Richtung, eine Isolatordicke (115) aufweist, die zwischen 0,04mm und 0,08mm beträgt und eine Spannungsfestigkeit von 10V/μm bis 30V/μm aufweist.

5.  Feldsondenkombination (100) nach einem oder mehreren der vorstehenden Ansprüche,
    **dadurch gekennzeichnet , dass**
    die Feldsondenkombination (100) aus einen an zwei Seiten teilweise mit Kupfer beschichteten PCB gebildet wird.

6.  Feldsondenkombination (100) nach einem oder mehreren der vorstehenden Ansprüche,
    **dadurch gekennzeichnet , das**s
    der Isolator (111) aus vorimprägnierten Fasern, insbesondere ein FR4 Material, oder einer Polyimid Folie gebildet ist.

7.  Feldsondenkombination (100) nach einem oder mehreren der vorstehenden Ansprüche,
    **dadurch gekennzeichnet , dass**
    die erste leitende Feldsondenschicht (120) und die zweite leitende Feldsondenschicht (122) aus Kupfer gebildet werden, wobei die erste leitende Feldsondenschicht (120) und die zweite leitende Feldsondenschicht (122) jeweils eine Dicke in radialer Richtung des Hohlzylinders des Isolators (111) zwischen 0,02mm und 0,05mm aufweisen.

8.  Feldsondenkombination (100) nach einem oder mehreren der vorstehenden Ansprüche,
    **dadurch gekennzeichnet, dass**
    die Feldsondenkombination (100) eine oder mehrere Vertiefungen oder Schlitzungen parallel zu der Symmetrieachse (101) des Hohlzylinders der Feldsondenkombination (100) aufweist. Die Schlitzungen sind dabei derart angeordnet, dass an Rändern des Hohlzylinders jeweils ein Steg bestehen bleibt.

9.  Feldsondenkombination (100) nach einem oder mehreren der vorstehenden Ansprüche,
    **dadurch gekennzeichnet, dass** Oberflächen der Feldsondenkombination (100), insbesondere die Oberflächen der ersten leitenden Feldsondenschicht (120) und der zweiten leitenden Feldsondenschicht (122), derart oberflächenbehandelt ist, dass diese Oberflächen eine erhöhte Rauigkeit aufweisen, als ohne die Oberflächenbehandlung.

10. Feldsondenkombination (100) nach Anspruch 9,
    **dadurch gekennzeichnet, dass**

    die erste leitende Feldsondenschicht (120) und die zweite leitende Feldsondenschicht (122) mit oder aus Kupfer gebildet sind und
    die Oberflächenbehandlung zumindest umfasst, dass auf den Oberflächen der ersten leitenden Feldsondenschicht (120) und der zweiten leitenden Feldsondenschicht (122) ein Kupfer(I)-Oxid und/oder Kupfer(II)-Oxid gebildet wird.

11. Feldsondenkombination (100) nach einem oder mehreren der vorstehenden Ansprüche,
    **dadurch gekennzeichnet, dass**
    die Feldsondenkombination (100) weiter zumindest einen Temperatursensor (130) aufweist, wobei der Temperatursensor (130) die Temperatur der Feldsondenkombination (100) misst und so eine Temperaturmesswert bestimmbar ist und der Temperaturmesswert zu einer Messwertkorrektur von gemessenen Spannungen mittels Temperaturkompensation heranziehbar ist.

12. Durchführung (10) für Mittel- und Hochspannungsschaltanlagen mit einer oder mehr Feldsondenkombinationen (100) nach einem oder mehreren der vorstehenden Ansprüche.

13. Schaltanlage (1) für Mittel- und Hochspannungsschaltanlagen mit einer oder mehr Durchführungen (10) nach Anspruch 12.

**Claims**

1.  Field probe combination (100) for use at medium and high voltages, having a first field probe (110) and a second field probe (112), wherein

    the first field probe (110) and the second field probe (112) are formed by a first conductive field probe layer (120) applied to an insulator (111) for the first field probe (110) and by a second conductive field probe layer (122) applied to the insulator (111) for the second field probe (112),
wherein the insulator (111) is the shape
of a hollow cylinder, or
a hollow cylinder that is slotted parallel to an axis of symmetry (101) of the field probe combination (100), wherein the insulator (111) has an insulator thickness (115) perpendicular to the axis of symmetry (101), that is to say in the radial direction, which separates the first conductive field probe layer (120) from the second conductive field probe layer (122), wherein the first conductive field probe layer (120) is arranged on a first side (116) of the insulator (111) radially facing towards the interior of the hollow cylinder and the second conductive field probe layer (122) is arranged on a second side (117) of the insulator (111) radially facing outward from the hollow cylinder,
wherein the first conductive field probe layer (120) has first contacting means (121) and the second conductive field probe layer (122) has second contacting means (123), wherein
a support structure (118) applied to the insulator (111) supports the field probe combination (100) in maintaining the hollow cylinder shape,
**characterized in that** the support structure (118) is formed from a conductive plastic and the support structure (118) is arranged circumferentially on an open edge of the hollow cylinder of the insulator (111).

2. Field probe combination (100) according to Claim 1, **characterized in that**

both the first contacting means (121) and the second contacting means (123) are arranged on the second side (117) of the hollow cylinder of the insulator (111),
wherein an electrically conductive connection between the first conductive field probe layer (120) and the contacting means (121) is guided through a through hole in the insulator (111).

3. Field probe combination (100) according to one or more of the preceding claims,
**characterized in that**
the first contacting means (121) and the second contacting means (123) are each formed as a soldering pad.

4. Field probe combination (100) according to one or more of the preceding claims,
**characterized in that**
the insulator (111) has an insulator thickness (115) between 0.04 mm and 0.08 mm and having a dielectric strength of 10 V/$\mu$m to 30 V/um, perpendicular to the axis of symmetry (101), i.e. in the radial direction.

5. Field probe combination (100) according to one or more of the preceding claims,
**characterized in that**
the field probe combination (100) is formed from a PCB that is partially coated with copper on two sides.

6. Field probe combination (100) according to one or more of the preceding claims,
**characterized in that**
the insulator (111) is formed from pre-impregnated fibres, in particular a FR4 material, or a polyimide film.

7. Field probe combination (100) according to one or more of the preceding claims,
**characterized in that**
the first conductive field probe layer (120) and the second conductive field probe layer (122) are formed from copper, wherein the first conductive field probe layer (120) and the second conductive field probe layer (122) each have a thickness in the radial direction of the hollow cylinder of the insulator (111) between 0.02 mm and 0.05 mm.

8. Field probe combination (100) according to one or more of the preceding claims,
**characterized in that**
the field probe combination (100) has one or more depressions or slots parallel to the axis of symmetry (101) of the hollow cylinder of the field probe combination (100), the slots are arranged here in such a way that a respective web remains at edges of the hollow cylinder.

9. Field probe combination (100) according to one or more of the preceding claims,
**characterized in that**
surfaces of the field probe combination (100), in particular the surfaces of the first conductive field probe layer (120) and the second conductive field probe layer (122), are surface-treated in such a way that these surfaces have an increased roughness than without the surface treatment.

**10.** Field probe combination (100) according to Claim 9,
**characterized in that**

the first conductive field probe layer (120) and the second conductive field probe layer (122) are formed with or from copper and
the surface treatment at least comprises a copper (I) oxide and/or copper (II) oxide is formed on the surfaces of the first conductive field probe layer (120) and the second conductive field probe layer (122).

**11.** Field probe combination (100) according to one or more of the preceding claims,
**characterized in that**
the field probe combination (100) further comprises at least one temperature sensor (130), wherein the temperature sensor (130) measures the temperature of the field probe combination (100) and thus a temperature measured value can be determined and the temperature measured value can be used for a measurement correction of measured voltages by means of temperature compensation.

**12.** Feedthrough (10) for medium-voltage and high-voltage switchgear assemblies having one or more field probe combinations (100) according to one or more of the preceding claims.

**13.** Switchgear assembly (1) for medium-voltage and high-voltage switchgear assemblies having one or more feedthroughs (10) according to Claim 12.

**Revendications**

**1.** Combinaison (100) de sondes de champ à utiliser dans les moyennes et hautes tensions, comprenant une première sonde (110) de champ et une deuxième sonde (112) de champ, dans laquelle

la première sonde (110) de champ et la deuxième sonde (112) de champ sont formées par une première couche (120) de sonde de champ conductrice déposée sur un isolateur (111) pour la première sonde (110) de champ et par une deuxième couche (122) de sonde de champ conductrice déposée sur l'isolateur (111) pour la deuxième sonde (112) de champ,
dans laquelle l'isolateur (111) a la forme d'un cylindre creux ou d'un cylindre creux fendu parallèlement à un axe (101) de symétrie de la combinaison (100) de sondes de champ, dans laquelle l'isolateur (111) a, perpendiculairement à l'axe (101) de symétrie, donc dans la direction radiale, une épaisseur (115) d'isolateur, qui sépare la première couche (120) de sonde de champ conductrice de la deuxième couche (122) de sonde de champ conductrice,
dans laquelle la première couche (120) de sonde de champ conductrice est disposée sur une première face (116) de l'isolateur (111), tournée vers l'intérieur radialement du cylindre creux, et la deuxième couche (122) de sonde de champ conductrice est disposée sur une deuxième face (117) de l'isolateur (111), tournée vers l'extérieur radialement du cylindre creux,
dans laquelle la première couche (120) de sonde de champ conductrice a un premier moyen (121) de mise en contact et la deuxième couche (122) de sonde de champ conductrice a un deuxième moyen (123) de mise en contact, dans laquelle
une structure (118) d'appui déposée sur l'isolateur (111) vient à l'appui de la combinaison (100) de sondes de champ pour conserver la forme de cylindre creux,
**caractérisée en ce que**
la structure (118) d'appui est en une matière plastique conductrice et la structure (118) d'appui est disposée en faisant le tour sur un bord ouvert du cylindre creux de l'isolateur (111).

**2.** Combinaison (100) de sondes de champ suivant la revendication 1,
**caractérisée en ce que**

tant le premier moyen (121) de mise en contact qu'également le deuxième moyen (123) de mise en contact sont disposés sur la deuxième face (117) du cylindre creux de l'isolateur (111),
dans laquelle une liaison conductrice de l'électricité, entre la première couche (120) de sonde de champ conductrice et le moyen (121) de mise en contact, passe dans un trou traversant de l'isolateur (111).

**3.** Combinaison (100) de sondes de champ suivant l'une ou plusieurs des revendications précédentes,

**caractérisée en ce que**

le premier moyen (121) de mise en contact et le deuxième moyen (123) de mise en contact sont constitués respectivement sous la forme d'une plage de brasure.

4. Combinaison (100) de sondes de champ suivant l'une ou plusieurs des revendications précédentes,
**caractérisée en ce que**
l'isolateur (111) a, perpendiculairement à l'axe (101) de symétrie, donc dans la direction radiale, une épaisseur (115) d'isolateur, qui est comprise entre 0,04 mm et 0,08 mm et qui a une rigidité diélectrique de 10 V/$\mu$m à 30 V/um.

5. Combinaison (100) de sondes de champ suivant l'une ou plusieurs des revendications précédentes,
**caractérisée en ce que**
la combinaison (100) de sondes de champ est formée d'un PCB revêtu de cuivre en partie de deux côtés.

6. Combinaison (100) de sondes de champ suivant l'une ou plusieurs des revendications précédentes,
**caractérisée en ce que**
l'isolateur (111) est formé de fibres pré-imprégnées, en particulier d'un matériau FR4 ou d'une feuille de polyimide.

7. Combinaison (100) de sondes de champ suivant l'une ou plusieurs des revendications précédentes,
**caractérisée en ce que**
la première couche (120) de sonde de champ conductrice et la deuxième couche (122) de sonde de champ conductrice sont en cuivre, dans laquelle la première couche (120) de sonde de champ conductrice et la deuxième couche (122) de sonde de champ conductrice ont chacune une épaisseur, dans la direction radiale du cylindre creux de l'isolateur (111), comprise entre 0,02 mm et 0,05 mm.

8. Combinaison (100) de sondes de champ suivant l'une ou plusieurs des revendications précédentes,
**caractérisée en ce que**
la combinaison (100) de sondes de champ a une ou plusieurs cavités ou fentes parallèlement à l'axe (101) de symétrie du cylindre creux de la combinaison (100) de sondes de champ, les fentes étant disposées de manière à ce qu'il subsiste, sur les bords du cylindre creux, respectivement une partie pleine.

9. Combinaison (100) de sondes de champ suivant l'une ou plusieurs des revendications précédentes,
**caractérisée en ce que**
des surfaces de la combinaison (100) de sondes de champ, en particulier des surfaces de la première couche (120) de sonde de champ conductrice et de la deuxième couche (122) de sonde de champ conductrice sont traitées en surface, de manière à ce que les surfaces aient une rugosité plus grande que sans le traitement de surface.

10. Combinaison (100) de sondes de champ suivant la revendication 9,
**caractérisée en ce que**

la première couche (120) de sonde de champ conductrice et la deuxième couche (122) de sonde de champ conductrice sont formées avec du cuivre ou sont en cuivre, et
le traitement de surface comprend au moins que l'on forme, sur les surfaces de la première couche (120) de sonde de champ conductrice et la deuxième couche (122) de sonde conductrice, un oxyde de cuivre (I) et/ou un oxyde de cuivre (II).

11. Combinaison (100) de sondes de champ suivant l'une ou plusieurs des revendications précédentes,
**caractérisée en ce que**
la combinaison (100) de sondes de champ a en outre au moins un capteur (130) de température, dans laquelle le capteur (130) de température mesure la température de la combinaison (100) de sondes de champ et il peut être ainsi déterminée une valeur de mesure de la température et la valeur de mesure de la température peut être mise à profit, au moyen d'une compensation de température pour une correction de valeurs de mesure de tensions mesurées.

12. Traversée (10) pour des installations de distribution de moyenne et de haute tension comprenant une ou plusieurs combinaisons (100) de sondes de champ suivant l'une ou plusieurs des revendications précédentes.

13. Installation (1) de coupure pour des installations de distribution de moyenne et de haute tension comprenant une ou plusieurs traversées (10) suivant la revendication 12.

FIG 1

FIG 2

FIG 3

FIG 4

# FIG 5

100

$U_q / U_{p1}$    $C_1 = \sim 10pF$

110

20

$I_{Mess}$

112

$U_{p2}$

140    $U_m$    $Z_{Messgerät}$

$C_2 = \sim 2nF$    145

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2409595
- DE 9412169 U1
- DE 60309277 T2
- DE 4426699 A1
- US 5053915 A
- US 2019234995 A1
- WO 2018108828 A1